# EUROPEAN PATENT SPECIFICATION

(11) **EP 3 240 376 B1**
(45) Date of publication and mention of the grant of the patent: **03.11.2021**
(21) Application number: 15877562.7
(22) Date of filing: 30.06.2015
(51) Int. Cl.: H05K 5/02, H05K 7/20, F28F 13/12

(54) **CABINET**
SCHRANK
ARMOIRE

(30) Priority: 15.01.2015 CN 201510019732
(43) Date of publication of application: 01.11.2017
(73) Proprietor: Huawei Technologies Co., Ltd., Shenzhen, Guangdong 518129 (CN)
(72) Inventor: TANG, Wenfei, Shenzhen Guangdong 518129 (CN); FU, Yongxiang, Shenzhen Guangdong 518129 (CN)
(74) Representative: Epping - Hermann - Fischer
(86) International application number: PCT/CN2015/082816
(87) International publication number: WO 2016/112647

(56) References cited:
- EP-A1- 2 180 775
- CN-A- 101 631 436
- CN-A- 101 873 790
- CN-A- 104 602 469
- CN-U- 203 824 403
- CN-U- 203 824 403
- CN-Y- 2 562 366
- DE-U1-202011 102 372
- JP-B2- 3 313 682
- US-A- 3 363 682
- US-A1- 2001 003 304
- US-A1- 2002 074 105
- US-A1- 2002 118 525
- US-A1- 2004 031 589
- US-A1- 2010 139 631
- US-A1- 2010 302 730
- US-A1- 2012 006 511

## Description

### TECHNICAL FIELD

The present invention relates to the field of heat dissipation technologies, and in particular, to a cabinet.

### BACKGROUND

In a prior-art cabinet, to ensure that an electronic device disposed in the cabinet can operate normally and stably under an allowed temperature condition, a heat dissipation structure is usually disposed, to provide the cabinet with good heat dissipation.

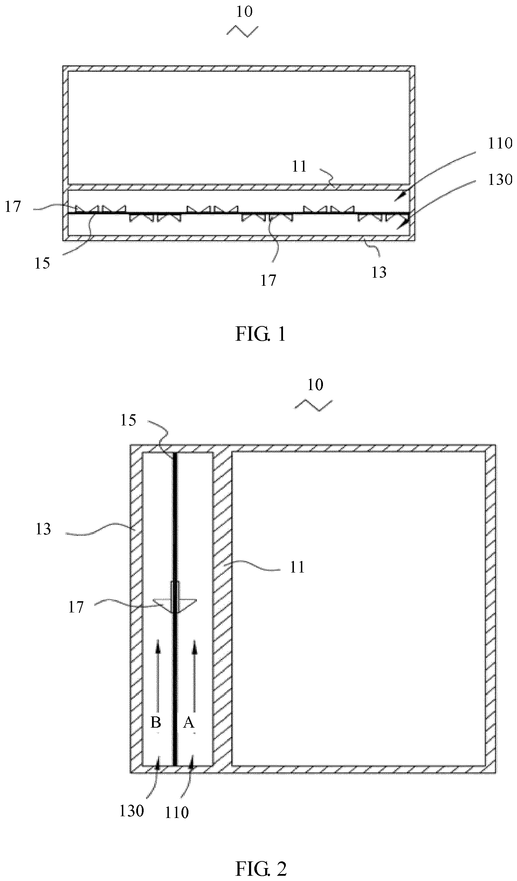

As shown in FIG. 1, a cabinet is available, in which an inner wall and an outer wall are disposed. A thermally conductive plate is disposed between the inner wall and the outer wall. The thermally conductive plate is a wrinkled plate on which grooves and protrusions are alternately disposed continuously. The thermally conductive plate divides space between the inner wall and the outer wall. Space between the outer wall and the thermally conductive plate is connected to the outside, and can cooperate with a fan or another flow guiding apparatus, to form an external circulation air duct, for exchanging air with the outside. Space between the inner wall and the thermally conductive plate is connected to an inside of the cabinet, and cooperates with a fan, to form an internal circulation air duct, for exchanging air with the inside of the cabinet. Air in the internal circulation air duct and air in the external circulation air duct exchange heat by using the thermally conductive plate.

However, in this type of cabinet, while a heat dissipation area is increased by densifying the wrinkled plate, flow resistance also rapidly increases correspondingly, causing a rise in fan power consumption and operating costs.

DE 20 2011 102 372 U1 discloses a housing comprising a housing body, wherein at least a wall body of the housing body includes a double wall which is an inner wall and an outer wall; wherein a heat conductive plate between the inner wall and the outer wall, said heat conductive plate is a folded plate, are alternately arranged on the recesses and protrusions, and wherein the heat conductive plate separates a region between the inner wall and the outer wall wherein a region between the outer wall and the heat conductive plate in exchange with the exterior is to form an outer circulation air passage to perform an exchange of air with the exterior; a region between the inner wall and the heat conductive plate in exchange with the interior of the housing to form an internal circulation air passage to perform an exchange of air with the interior of the housing; and air carried in the inner circulation air passage to a heat exchange with air in the outer circulation air passage through the heat conductive plate.

US 2010/139631 A1 discloses a heat exchanger with at least one duct, which can be flowed through by flowing medium from an inlet cross-section to an outlet cross-section, has an inside and outside, and which comprises, on the inside, structural elements for increasing the transfer of heat. The structural elements are variably arranged and/or configured in the direction of flow so that the duct, on the inside, has a variable heat transfer that, in particular, increases in the direction of flow.

CN 203824403 U discloses a fin of an air heat exchanger. The fin of the air heat exchanger is characterized by being composed of a corrugated rib plate; a plurality of left windows and a plurality of right windows are formed in the corrugated rib plate in the direction of a wind path; the left windows are arranged corresponding to an air inlet, and the right windows are arranged corresponding to an air outlet; the corrugated rib plate is further provided with a plurality of spoilers and a plurality of airflow disturbing holes; the spoilers are arranged on the surface of the corrugated rib plate in a protruding mode; each spoiler body is provided with an airflow disturbing faces in a concave arc shape; the airflow disturbing holes are formed in the corrugated rib plate corresponding to the spoilers and penetrate through the obverse side and the reverse side of the corrugated rib plate; the spoilers and the airflow disturbing holes are arranged between the air inlet and the left windows, between the left windows and the right windows and between the right windows and the air outlet of the corrugated rib plate in pairs; the included angle between the spoiler body of each spoiler and an air passage ranges from 20 degrees to 70 degrees. The fin of the air heat exchanger solves the problem that a traditional heat exchanger is prone to dust deposition, has excellent heat exchange performance after long-term use and prolongs the service life of the heat exchanger.

US 2001/003304 A1 discloses a heat exchanger and a method of manufacturing the heat exchanger for dissipating heat from a heat generating component. The heat exchanger comprises a thermally conductive base in thermal communication with the component, a plurality of thermally conductive plate fins affixed to the base wherein the plate fins define a fin field and channels, and fluid control for controlling the fluid flow within the fin field. The individual fins of the heat exchanger comprise textured regions positioned about a side surface of the fins and extending into an adjacent channel. The positioning of the textured regions function to minimize formation of high pressure within the fin field by disturbing the fluid flow passing along the fins. The heat exchanger may comprise a fluid control feature for substantially preventing premature egress of fluid from a top region of the fin field caused by the high pressure region within the fin field.

US 2010/302730 A1 discusses the use of vortex generators to improve efficacy of heat sinks used to cool telecommunications, electrical and electro-optical components.

US 2002/074105 A1 discloses a heat exchanger, in which a plurality of sets of two louvres substantially triangular in shape are formed in such a manner that the distance from a flat plate portion increases progressively downstream in an EGR gas flow. The two louvres of each set are arranged inwardly slanted along the exhaust gas flow, so that a vertical swirl is generated to draw the EGR gas flow between the louvres. The EGR gas flowing in the vicinity of the flat plate portion and the EGR gas flowing in the vicinity of a vertical plate portion are thus accelerated. As a result, the heat conductivity of the EGR gas and the fins are improved and the particulate flatter attached on the surface of the fins can be blown off, thereby preventing the clogging of the fins.

US 2004/031589 A1 discloses a heat sink with an air guide apparatus that comprises a plurality of air guides. The air guide is disposed on the surface of heat sink, and the inlet slopes down to the outlet for leading orderly to enhance the cooling performance. The heat sink apparatus could lead effectively the heat and add the touch surface in accordance with the sloping air guide for enhancing the cooling performance.

EP 2 180 775 A1 discloses an equipment case. The case comprises a sealed housing unit configured to receive an item of equipment. Cooling means, associated with the housing unit, are provided for maintaining an operational thermal environment within the equipment case.

US 2012/006511 A1 a heat exchanger includes a plurality of channels and one or more active flow disruption members disposed at an entrance to the plurality of channels. The active flow disruption members are configured to induce unsteadiness in a flow through the plurality of channels to increase thermal energy transfer in the plurality of channels. A method for transferring thermal energy from a heat exchanger includes locating one or more active flow disruption members at an entrance to a plurality of channels of the heat exchanger. A flow is directed across the one or more active flow disruption members into the plurality of channels and an unsteadiness is produced in the flow via the one or more active flow disruption members. The unsteadiness in the flow increases the transfer of thermal energy between the heat exchanger and the flow.

US 3 363 682 A discloses heat exchangers and is concerned with the promotion of increased rates of heat transfer in heat exchangers of a wide variety.

### SUMMARY

A cabinet with a better heat exchanging effect and better air-tightness is provided. According to the invention, a cabinet is provided, where: an inner wall and an outer wall are disposed in the cabinet, and a cavity is formed between the inner wall and the outer wall; a thermally conductive plate is further disposed in the cabinet, where the thermally conductive plate is disposed between the inner wall and the outer wall and divides the cavity into an internal cavity and an external cavity that are mutually isolated, the internal cavity and an inside of the cabinet are interconnected, to form an internal circulation air flow, and the external cavity and an outside of the cabinet are interconnected, to form an external circulation air flow; a flow disturbing panel is further disposed in the cabinet, where the flow disturbing panel is disposed in the internal cavity or/and the external cavity, and is configured to convert the internal circulation air flow or/and the external circulation air flow into a vortex flow. The thermally conductive plate is a zigzag shape, at least two protruding first protrusion parts facing the inner wall and at least two protruding second protrusion parts facing the outer wall are disposed on the thermally conductive plate, a gap between two adjacent first protrusion parts forms a first airway in which the internal circulation air flow flows, a gap between two adjacent second protrusion parts forms a second airway in which the internal circulation air flow flows.

A connecting piece is further disposed in the cabinet, the connecting piece is a U-shaped sheet and is clamped and fastened on the first protrusion part or the second protrusion part, and the flow disturbing panel is connected to the connecting piece so that the flow disturbing panel disposed on an outside of the connecting piece is placed in the first airway or the second airway.

In a first possible implementation manner of the invention, an included angle between the flow disturbing panel and a flow direction of the internal circulation air flow and/or an included angle between the flow disturbing panel and a flow direction of the external circulation air flow range/ranges from 15 degrees to 75 degrees.

With reference to the first possible implementation manner of the invention, in a second possible implementation manner, the included angle between the flow disturbing panel and the flow direction of the internal circulation air flow and/or the included angle between the flow disturbing panel and the flow direction of the external circulation air flow are/is 45 degrees.

In a third possible implementation manner of the invention, the flow disturbing panel is any one of a triangle-shaped panel, a rectangle-shaped panel, a trapezoid-shaped panel, or a parallelogram-shaped panel.

In a fourth possible implementation manner of the invention, at least one of the flow disturbing panel is disposed in any one first airway, and at least one of the flow disturbing panel is disposed in any one second airway and at least one pair of the flow disturbing panels is disposed in each first airway or each second airway, and the two flow disturbing panels in each pair of flow disturbing panels are mirror-symmetric.

In a fifth possible implementation manner of the invention, an included angle between the pair of flow disturbing panels is 90 degrees.

In a sixth possible implementation manner of the invention, the flow disturbing panel is molded into one piece with the connecting piece.

With reference to any one of the invention or the first to the third possible implementation manners of the invention, in a seventh possible implementation manner of the invention, multiple columns of the flow disturbing panels are disposed in the cabinet along an air flow direction in multiple first airways, the flow disturbing panels in adjacent columns are located in different first airways.

With reference to any one of the invention or the first to the third possible implementation manners of the invention, in an eighth possible implementation manner of the invention, multiple columns of the flow disturbing panels are disposed in the cabinet along an air flow direction in multiple second airways, the flow disturbing panels in adjacent columns are located in different second airways.

In the cabinet according to the present invention, a thermally conductive plate is disposed. An internal cavity and an external cavity that are used for air circulation are formed on an inside and an outside of the thermally conductive plate in cooperation with an inner wall and an outer wall of the cabinet. In this way, internal space and external space of the cabinet exchange heat by using the thermally conductive plate. Because the thermally conductive plate separates the internal cavity and the external cavity, an internal sealing effect of the cabinet can be ensured. In the cabinet according to the present invention, by disposing a flow disturbing panel, a heat exchanging capability of the thermally conductive plate can be greatly improved while slightly increasing flow resistance to an air flow, thereby improving overall heat dissipation efficiency of the cabinet.

### BRIEF DESCRIPTION OF DRAWINGS

To describe the technical solutions in the embodiments of the present invention or in the prior art more clearly, the following briefly describes the accompanying drawings required for describing the embodiments or the prior art. Apparently, the accompanying drawings in the following description show merely some embodiments of the claimed invention, and a person of ordinary skill in the art may still derive other drawings from these accompanying drawings without creative efforts.
FIG. 1 is a schematic sectional view of a cabinet from a top perspective according to an implementation manner not according to the claimed invention;
FIG. 2 is a schematic sectional view of a cabinet from a lateral perspective according to an implementation manner not according to the claimed invention;
FIG. 3 is a schematic structural diagram of a flow disturbing panel according to an implementation manner not according to the claimed invention;
FIG. 4 is a schematic sectional view of a cabinet from a top perspective according to an implementation manner of the present invention;
FIG. 5 is a locally enlarged schematic diagram of FIG. 4;
FIG. 6 is a schematic structural diagram of a thermally conductive plate according to an implementation manner of the present invention;

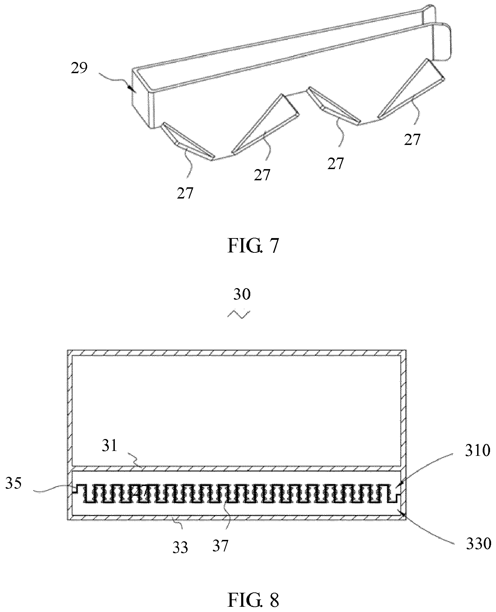

FIG. 7 is a schematic structural diagram of a flow disturbing panel according to an implementation manner of the present invention;
FIG. 8 is a schematic sectional view of a cabinet from a top perspective according to an implementation manner of the present invention;

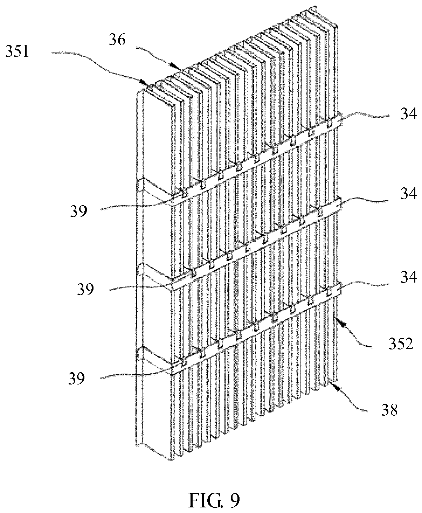

FIG. 9 is a schematic structural diagram of a thermally conductive plate according to an implementation manner of the present invention; and

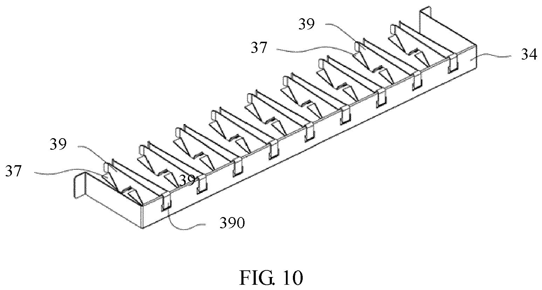

FIG. 10 is a schematic structural diagram of a flow disturbing panel according to an implementation manner of the present invention.

### DESCRIPTION OF EMBODIMENTS

Referring to FIG. 1 and FIG. 2, an implementation manner of an embodiment not according to the invention provides a cabinet 10. An inner wall 11 and an outer wall 13 are disposed on at least one side of the cabinet 10, and a cavity is formed between the inner wall 11 and the outer wall 13.

A thermally conductive plate 15 is further disposed in the cabinet 10. The thermally conductive plate 15 is disposed between the inner wall 11 and the outer wall 13 and divides the cavity into an internal cavity 110 and an external cavity 130 that are mutually isolated. The internal cavity 110 is formed between the thermally conductive plate 15 and the inner wall 11, and the external cavity 130 is formed between the thermally conductive plate 15 and the outer wall 13. The internal cavity 110 and an inside of the cabinet 10 are interconnected, to form an internal circulation air flow A, and the external cavity 130 and an outside of the cabinet 10 are interconnected, to form an external circulation air flow B. The internal circulation air flow A and the external circulation air flow B exchange heat by using the thermally conductive plate 15.

In this embodiment not according to the invention, the thermally conductive plate 15 is a shape of a slab. It can be understood that the thermally conductive plate 15 may use any other suitable shape, for example, a wrinkled plate or a corrugated plate, provided that the thermally conductive plate 15 can divide the cavity into the internal cavity 110 and the external cavity 130 that are mutually disconnected.

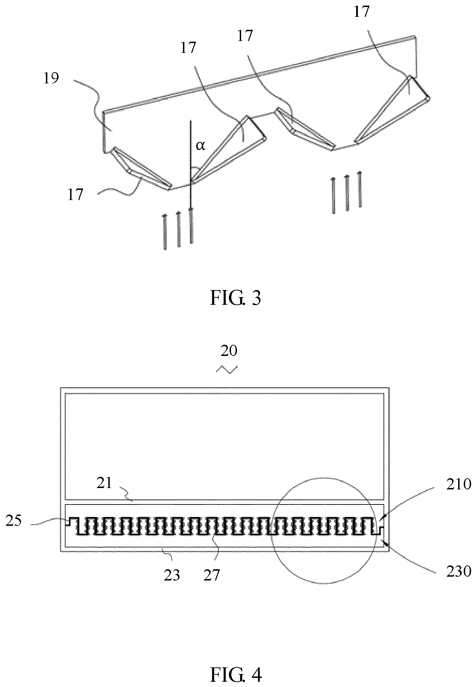

As shown in FIG. 3, a flow disturbing panel 17 is further disposed in the cabinet 10, where the flow disturbing panel 17 is disposed in the cavity, and is configured to convert the internal circulation air flow A and the external circulation air flow B into a vortex flow. In application, the flow disturbing panel 17 may make an air flow to rotate tangentially, to form a longitudinal vortex that progresses in an air flow direction. The longitudinal vortex may produce rotation and entrainment effects, thereby enhancing a heat exchanging effect of the thermally conductive plate 15.

It can be understood that the flow disturbing panel 17 may be disposed in the internal cavity 110 or the external cavity 130, or may be disposed in both the internal cavity 110 and the external cavity 130.

Specifically, the internal circulation air flow A and the external circulation air flow B in the cabinet 10 flow in a direction parallel to the thermally conductive plate 15. As shown in FIG. 3, an included angle α between the flow disturbing panel 17 and the internal circulation air flow A and/or an included angle α between the flow disturbing panel 17 and the external circulation air flow B range/ranges from 15 degrees to 75 degrees. For example, the included angle α between the flow disturbing panel 17 and the internal circulation air flow and/or the included angle α between the flow disturbing panel 17 and the external circulation air flow are/is 45 degrees. The flow disturbing panel 17 may disturb an air flow passing through the flow disturbing panel 17, to change the air flow into a longitudinal vortex flow. The flow disturbing panel 17 may be a triangle-shaped panel, a rectangle-shaped panel, a trapezoid-shaped panel, or a parallelogram-shaped panel. For example, the flow disturbing panel 17 uses a triangle.

The flow disturbing panel 17 may be disposed in the internal cavity 110 or the external cavity 130 in any suitable manner. The thermally conductive plate 15 may be made of metal or another suitable material with high thermal conductivity.

In this embodiment not according to the invention, a connecting piece 19 is further disposed in the cabinet 10. The connecting piece 19 is configured to dispose the flow disturbing panel 17 in the internal cavity 110 and/or the external cavity 130. In this embodiment not according to the invention, the connecting piece 19 is a shape of a slab, and the flow disturbing panel 17 is disposed on the connecting piece 19. The connecting piece 19 may be connected to the inner wall 11, the outer wall 13, or the thermally conductive plate 15 in the cabinet 10 in any suitable manner. Further, the flow disturbing panel 17 may be molded into one piece with the connecting piece 19, and the flow disturbing panel 17 is bent relative to the connecting piece 19. The connecting piece 19 may be connected to the inner wall 11, the outer wall 13, or the thermally conductive plate 15 in the cabinet 10 by means of welding or cementation. It can be understood that, the flow disturbing panel 17 may be directly disposed on the inner wall 11, the outer wall 13, or the thermally conductive plate 15 in the cabinet 10, provided that the flow disturbing panel 17 can produce a disturbing flow and an isolation effect of the thermally conductive plate 15 is not compromised.

In this embodiment not according to the invention, the connecting piece 19 is connected to the thermally conductive plate 15. This is convenient for the flow disturbing panel 17 disposed on the connecting piece 19 to disturb an air flow close to the thermally conductive plate 15, thereby enhancing a heat exchanging effect of the thermally conductive plate 15.

In the cabinet 10 not according to the present invention, a thermally conductive plate 15 is disposed. An internal cavity 110 and an external cavity 130 that are used for air circulation are formed on an inside and an outside of the thermally conductive plate 15 in cooperation with an inner wall 11 and an outer wall 13 of the cabinet 10. In this way, internal space and external space of the cabinet 10 exchange heat by using the thermally conductive plate 15. Because the thermally conductive plate 15 separates the internal cavity 110 and the external cavity 130, an internal sealing effect of the cabinet 10 can be ensured. In addition, in the cabinet 10 according to the present invention, by disposing a flow disturbing panel 17, a heat exchanging capability of the thermally conductive plate 15 can be greatly improved while slightly increasing flow resistance to an air flow, thereby improving overall heat dissipation efficiency of the cabinet 10.

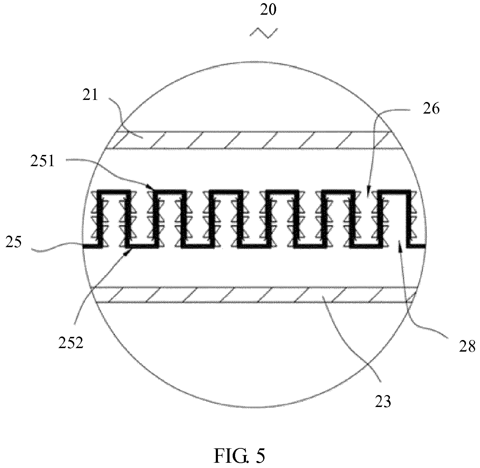

Referring to FIG. 4 to FIG. 5, an embodiment of the present invention provides a cabinet 20. The cabinet 20 in this embodiment is approximately the same as the cabinet 10 provided in the first embodiment, and includes an inner wall 21, an outer wall 23, and a thermally conductive plate 25. A cavity is formed between the inner wall 21 and the outer wall 23. The thermally conductive plate 25 is disposed between the inner wall 21 and the outer wall 23, and divides the cavity into an internal cavity 210 and an external cavity 230 that are mutually isolated. The internal cavity 210 and an inside of the cabinet 20 are interconnected, to form an internal circulation air flow, and the external cavity 230 and an outside of the cabinet 20 are interconnected, to form an external circulation air flow. A flow disturbing panel 27 is further disposed in the cabinet 20, where the flow disturbing panel 27 is disposed in the cavity, and is configured to convert the internal circulation air flow and the external circulation air flow into a vortex flow.

A difference lies in that: in this embodiment, the thermally conductive plate 25 is a zigzag shape. At least two protruding first protrusion parts 251 facing the inner wall 21 and at least two protruding second protrusion parts 252 facing the outer wall 23 are disposed on the thermally conductive plate 25.

A gap between two adjacent first protrusion parts 251 forms a first airway 26 in which the internal circulation air flow flows. A gap between two adjacent second protrusion parts 252 forms a second airway 28 in which the external circulation air flow flows. At least one flow disturbing panel 27 is disposed in the first airway 26. At least one flow disturbing panel 27 is disposed in the second airway 28.

In this embodiment, the thermally conductive plate 25 is a zigzag shape, so that a heat dissipation area of the thermally conductive plate 25 is increased, improving a heat dissipation effect of the thermally conductive plate 25. In addition, the first protrusion parts 251 and the second protrusion parts 252 disposed on the thermally conductive plate 25 can form the first airway 26 and the second airway 28 in which air flows flow. The flow disturbing panel 27 is disposed in the first airway 26 or the second airway 28, so that an air flow in the first airway 26 or the second airway 28 forms a longitudinal vortex, improving flow disturbance efficiency of the flow disturbing panel 27.

In this embodiment, cross sections of the first protrusion parts 251 and the second protrusion parts 252 assume a rectangle shape. It can be understood that, cross sections of the first protrusion parts 251 and the second protrusion parts 252 may assume another shape such as a V shape, a U shape, or a trapezoid shape, provided that the first airway 26 can be formed between two adjacent first protrusion parts 251 and that the second airway 28 can be formed between two adjacent second protrusion parts 252.

Further, at least one pair of flow disturbing panels 27 is disposed in each first airway 26 or each second airway 28, and the two flow disturbing panels 27 in each pair of flow disturbing panels 27 are mirror-symmetric. By disposing the pair of flow disturbing panels 27, two longitudinal vortexes rotating in reverse directions can be formed in the air duct.

Further, in this embodiment, a connecting piece 29 is disposed in the cabinet 20, and is configured to dispose the flow disturbing panel 27 in the cavity. The connecting piece 29 is a U-shaped sheet and can be clamped and fastened on the first protrusion part 251 or the second protrusion part 252. In this embodiment, the flow disturbing panel 27 is molded into one piece with the connecting piece 29 and is bent relative to the connecting piece 29. The connecting piece 29 may be clamped and fastened on the first protrusion part 251 or the second protrusion part 252, so that the flow disturbing panel 27 disposed on an outside of the connecting piece 29 is placed in the first airway 26 or the second airway 28. It can be understood that, the connecting piece 29 may be permanently connected to the thermally conductive plate 25 by means of welding. The flow disturbing panel 27 may be directly welded on the thermally conductive plate 25.

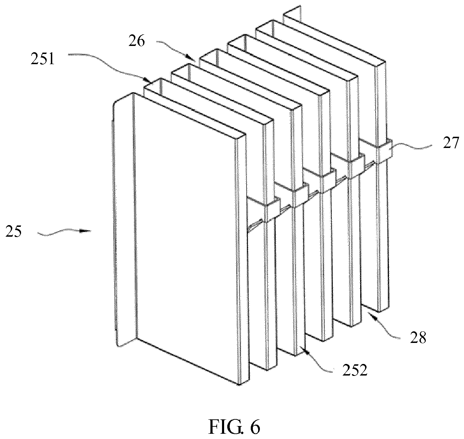

Referring to FIG. 6, another embodiment of the present invention provides a cabinet 30. The cabinet 30 in this embodiment is approximately the same as the cabinet 20 provided in the first embodiment, and includes an inner wall 31, an outer wall 33, and a thermally conductive plate 35. A cavity is formed between the inner wall 31 and the outer wall 33. The thermally conductive plate 35 is disposed between the inner wall 31 and the outer wall 33, and divides the cavity into an internal cavity 310 and an external cavity 330 that are mutually isolated. The internal cavity 310 and an inside of the cabinet 30 are interconnected, to form an internal circulation air flow, and the external cavity 330 and an outside of the cabinet 30 are interconnected, to form an external circulation air flow. A flow disturbing panel 37 is further disposed in the cabinet 30, where the flow disturbing panel 37 is disposed in the cavity, and is configured to convert the internal circulation air flow and the external circulation air flow into a vortex flow. In this embodiment, the thermally conductive plate 35 is a zigzag shape. At least two protruding first protrusion parts 351 facing the inner wall 31 and at least two protruding second protrusion parts 352 facing the outer wall 33 are disposed on the thermally conductive plate 35. A gap between two adjacent first protrusion parts 351 forms a first airway 36 in which the internal circulation air flow flows. A gap between two adjacent second protrusion parts 352 forms a second airway 38 in which the internal circulation air flow flows.

A difference lies in that, in this embodiment, the gap between the two adjacent first protrusion parts 351 is less than the gap between the two adjacent second protrusion parts 352. Therefore, a cross-sectional area of the first air duct 36 is less than a cross-sectional area of the second air duct 38, so that there is a relatively large air flow volume in the second air duct 38 connected to the outside of the cabinet 30, thereby improving a heat exchanging effect of the cabinet 30.

Further, a positioning frame 34 and a connecting piece 39 are disposed in the cabinet 30. The flow disturbing panel 37 is permanently installed on the thermally conductive plate 35 by using the connecting piece 39 and the positioning frame 34. In this embodiment, the positioning frame 34 is disposed in the external cavity 330.

The positioning frame 34 is a shape of a slab and is disposed on an outside of the second protrusion part 352 of the thermally conductive plate 35, and the positioning frame 34 is approximately parallel to the outer wall 33. Two ends of the positioning frame 34 are permanently connected to the thermally conductive plate 35.

A hook 390 is disposed in the middle of the connecting piece 39, and the hook 390 is configured to connect to the positioning frame 34. The flow disturbing panel 37 is disposed on an outside of the connecting piece 39. The connecting piece 39 is clamped and fastened on the second protrusion part 352, and the flow disturbing panel 37 is located in the second air duct 38.

In this embodiment, multiple flow disturbing panels 37 are disposed on the positioning frame 34. A quantity of disposed connecting pieces 39 is the same as a quantity of second protrusion parts 352 of the thermally conductive plate 35, that is, one connecting piece 39 is correspondingly disposed for each second protrusion part. Several flow disturbing panels 37 are disposed on each connecting piece 39.

Further, in this embodiment, two pairs of flow disturbing panels 37 are disposed on either side of the connecting piece 39, and the two flow disturbing panels 37 in each pair of flow disturbing panels 37 are mirror-symmetric.

It can be understood that, the positioning frame 34 may also be disposed in the internal cavity 310. A manner of permanently installing the positioning frame 34 is consistent with the manner described above, and details are not described herein again. The connecting piece 39 may be clamped and fastened on the first protrusion part 351 or the second protrusion part 352, so that the flow disturbing panel 37 disposed on the outside of the connecting piece 39 is placed in the first airway 36 or the second airway 38. It can be understood that, the connecting piece 39 may be permanently connected to the thermally conductive plate 35 by means of welding. The flow disturbing panel 37 may be directly welded on the thermally conductive plate 35.

Further, multiple positioning frames 34 that are parallel to each other may be disposed in the cabinet 30, at least multiple connecting pieces 39 configured to dispose the flow disturbing panel 37 are disposed on each positioning frame 34. As shown in the figure, in this embodiment, the multiple positioning frames 34 are arranged in sequence in an extension direction of the multiple second air ducts 38, and flow disturbing panels 37 disposed on two adjacent columns of positioning frames 34 are located in different second air ducts 38. This ensures that flow disturbing panels 37 disposed in an air flow direction in a second air duct are not too crowded, avoiding overlarge flow resistance to an air flow.

What are disclosed above are merely embodiments of the present invention, and certainly are not intended to limit the protection scope of the present invention. All embodiments in accordance with the claims shall fall within the scope of the present invention.

## Claims

1. A cabinet, wherein: an inner wall (21, 31) and an outer wall (23, 33) are disposed in the cabinet, and a cavity is formed between the inner wall (21, 31) and the outer wall (23, 33); a thermally conductive plate (25, 35) is further disposed in the cabinet, wherein the thermally conductive plate (25, 35) is disposed between the inner wall (21, 31) and the outer wall (23, 33) and divides the cavity into an internal cavity (210) and an external cavity (230) that are mutually isolated, the internal cavity (210) and an inside of the cabinet are interconnected, to form an internal circulation air flow (A), and the external cavity (230) and an outside of the cabinet are interconnected, to form an external circulation air flow (B); a flow disturbing panel (27, 37) is further disposed in the cabinet, wherein the flow disturbing panel (27, 37) is disposed in the internal cavity (210) or/and the external cavity (230), and is configured to convert the internal circulation air flow (A) or/and the external circulation air flow (B) into a vortex flow;
wherein the thermally conductive plate (25, 35) is a zigzag shape, at least two protruding first protrusion parts (251, 351) facing the inner wall (21, 31) and at least two protruding second protrusion parts (252, 352) facing the outer wall (23, 33) are disposed on the thermally conductive plate (25, 35), a gap between two adjacent first protrusion parts (251, 351) forms a first airway (26,36) in which the internal circulation air flow (A) flows, a gap between two adjacent second protrusion parts (252, 352) forms a second airway (28,38) in which the external circulation air flow (B) flows;
**characterized in that**
a connecting piece (29, 39) is further disposed in the cabinet, the connecting piece (19, 29, 39) is a U-shaped sheet and is clamped and fastened on the first protrusion part (251, 351) or the second protrusion part (252,352), and the flow disturbing panel (27, 37) is connected to the connecting piece (29, 39) so that the flow disturbing panel (27,37) disposed on an outside of the connecting piece is placed in the first airway (26,36) or the second airway (28,38).

2. The cabinet according to claim 1, wherein an included angle between the flow disturbing panel (27, 37) and a flow direction of the internal circulation air flow (A) and/or an included angle between the flow disturbing panel (27, 37) and a flow direction of the external circulation air flow (B) range/ranges from 15 degrees to 75 degrees.

3. The cabinet according to claim 2, wherein the included angle between the flow disturbing panel (27, 37) and the flow direction of the internal circulation air flow (A) and/or the included angle between the flow disturbing panel (27, 37) and the flow direction of the external circulation air flow (B) are/is 45 degrees.

4. The cabinet according to claim 1, wherein the flow disturbing panel (27, 37) is any one of a triangle-shaped panel, a rectangle-shaped panel, a trapezoid-shaped panel, or a parallelogram-shaped panel.

5. The cabinet according to claim 1, wherein at least one of the flow disturbing panel (27, 37) is disposed in any one first airway (26,36), and at least one of the flow disturbing panel (27, 37) is disposed in any one second airway (28,38) and wherein at least one pair of the flow disturbing panels (27, 37) is disposed in each first airway (26,36) or each second airway (28,38), and the two flow disturbing panels (27, 37) in each pair of flow disturbing panels (27, 37) are mirror-symmetric.

6. The cabinet according to claim 5, wherein an included angle between the pair of flow disturbing panels (27, 37) is 90 degrees.

7. The cabinet according to claim 1, wherein the flow disturbing panel (27, 37) is molded into one piece with the connecting piece (29, 39).

8. The cabinet according to any one of claims 1 to 4, wherein multiple columns of the flow disturbing panels (27, 37) are disposed in the cabinet along an air flow direction in multiple first airways (26,36), the flow disturbing panels (27, 37) in adjacent columns are located in different first airways (26,36).

9. The cabinet according to any one of claims 1 to 4, wherein multiple columns of the flow disturbing panels (27, 37) are disposed in the cabinet along an air flow direction in multiple second airways (28,38), the flow disturbing panels in adjacent columns are located in different second airways (28,38).

## Patentansprüche

1. Schrank, wobei: eine Innenwand (21, 31) und eine Außenwand (23, 33) in dem Schrank angeordnet sind und zwischen der Innenwand (21, 31) und der Außenwand (23, 33) ein Hohlraum gebildet ist; in dem Schrank ferner eine wärmeleitende Platte (25, 35) angeordnet ist, wobei die wärmeleitende Platte (25, 35) zwischen der Innenwand (21, 31) und der Außenwand (23, 33) angeordnet ist und den Hohlraum in einen inneren Hohlraum (210) und einen äußeren Hohlraum (230), die voneinander isoliert sind, unterteilt, wobei der innere Hohlraum (210) und ein Innenbereich des Schranks miteinander verbunden sind, um einen inneren Zirkulationsluftstrom (A) zu erzeugen, und der äußere Hohlraum (230) und ein Außenbereich des Schranks miteinander verbunden sind, um einen äußeren Zirkulationsluftstrom (B) zu bilden; in dem Schrank ferner ein strömungsstörendes Paneel (27, 37) angeordnet ist, wobei das strömungsstörende Paneel (27, 37) in dem inneren Hohlraum (210) oder/und dem äußeren Hohlraum (230) angeordnet ist und dazu ausgebildet ist, den inneren Zirkulationsluftstrom (A) und/oder den äußeren Zirkulationsluftstrom (B) in einen Wirbelstrom umzuwandeln;
wobei die wärmeleitende Platte (25, 35) zickzackförmig ist, mindestens zwei hervorstehende erste Vorsprungsteile (251, 351), die der Innenwand (21, 31) zugekehrt sind, und mindestens zwei hervorstehende zweite Vorsprungsteile (252, 352), die der Außenwand (23, 33) zugekehrt sind, an der wärmeleitenden Platte (25, 35) angeordnet sind, ein Spalt zwischen zwei benachbarten ersten Vorsprungsteilen (251, 351) einen ersten Luftweg (26, 36) bildet, in dem der innere Zirkulationsluftstrom (A) strömt, ein Spalt zwischen zwei benachbarten Vorsprungsteilen (252, 352) einen zweiten Luftstrom (28, 38) bildet, in dem der äußere Zirkulationsluftstrom (B) strömt;
**dadurch gekennzeichnet, dass**
in dem Schrank ferner ein Verbindungsstück (29, 39) angeordnet ist, wobei das Verbindungsstück (19, 29, 39) ein U-förmiges Flächengebilde ist und an dem ersten hervorstehenden Teil (251, 351) oder dem zweiten hervorstehenden Teil (252, 352) befestigt ist und das strömungsstörende Paneel (27, 37) mit dem Verbindungsstück (29, 39) verbunden ist, so dass das auf einer Außenseite des Verbindungsstücks angeordnete strömungsstörende Paneel (27, 37) in dem ersten Luftweg (26, 36) oder dem zweiten Luftweg (28, 38) platziert ist.

2. Schrank nach Anspruch 1, wobei ein zwischen dem strömungsstörenden Paneel (27, 37) und einer Strömungsrichtung des inneren Zirkulationsluftstroms (A) eingeschlossener Winkel und/oder ein zwischen dem strömungsstörenden Paneel (27, 37) und einer Strömungsrichtung des äußeren Zirkulationsluftstroms (B) eingeschlossener Winkel zwischen 15 Grad und 75 Grad liegt/liegen.

3. Schrank nach Anspruch 2, wobei der zwischen dem strömungsstörenden Paneel (27, 37) und der Strömungsrichtung des inneren Zirkulationsluftstroms (A) eingeschlossene Winkel und/oder der zwischen dem strömungsstörenden Paneel (27, 37) und der Strömungsrichtung des äußeren Zirkulationsluftstroms (B) eingeschlossene Winkel 45 Grad beträgt/betragen.

4. Schrank nach Anspruch 1, wobei das strömungsstörende Paneel (27, 37) eines von einem dreieckförmigen Paneel, einem rechteckförmigen Paneel, einem trapezförmigen Paneel oder einem parallelogrammförmigen Paneel ist.

5. Schrank nach Anspruch 1, wobei mindestens eines von dem strömungsstörenden Paneel (27, 37) in irgendeinem ersten Luftweg (26, 36) angeordnet ist und mindestens eines von dem strömungsstörenden Paneel (27, 37) in einem beliebigen zweiten Luftweg (28, 38) angeordnet ist und wobei mindestens ein Paar der strömungsstörenden Paneele (27, 37) in jedem ersten Luftweg (26, 36) oder jedem zweiten Luftweg (28, 38) angeordnet ist und die beiden strömungsstörenden Paneele (27, 37) in jedem Paar strömungsstörender Paneele (27, 37) spiegelsymmetrisch sind.

6. Schrank nach Anspruch 5, wobei ein zwischen dem Paar strömungsstörender Paneele (27, 37) eingeschlossener Winkel 90 Grad beträgt.

7. Schrank nach Anspruch 1, wobei das strömungsstörende Paneel (27, 37) einstückig mit dem Verbindungsstück (29, 39) geformt ist.

8. Schrank nach einem der Ansprüche 1 bis 4, wobei mehrere Säulen der strömungsstörenden Paneele (27, 37) in dem Schrank entlang einer Luftstromrichtung in mehreren ersten Luftwegen (26, 36) angeordnet sind, die strömungsstörenden Paneele (27, 37) in benachbarten Säulen in anderen ersten Luftwegen (26, 36) positioniert sind.

9. Schrank nach einem der Ansprüche 1 bis 4, wobei mehrere Säulen der strömungsstörenden Paneele (27, 37) in dem Schrank entlang einer Luftstromrichtung in mehreren zweiten Luftwegen (28, 38) angeordnet sind, die strömungsstörenden Paneele in benachbarten Säulen in anderen zweiten Luftwegen (28, 38) positioniert sind.

## Revendications

1. Armoire : une paroi interne (21, 31) et une paroi externe (23, 33) étant disposées dans l'armoire, et une cavité étant formée entre la paroi interne (21, 31) et la paroi externe (23, 33) ; une plaque thermoconductrice (25, 35) étant en outre disposée dans l'armoire, la plaque thermoconductrice (25, 35) étant disposée entre la paroi interne (21, 31) et la paroi externe (23, 33) et divisant la cavité en une cavité interne (210) et une cavité externe (230) qui sont mutuellement isolées, la cavité interne (210) et un intérieur de l'armoire étant raccordés, pour former un flux d'air de circulation interne (A), et la cavité externe (230) et un extérieur de l'armoire étant raccordés, pour former un flux d'air de circulation externe (B), un panneau de perturbation de flux (27, 37) étant en outre disposé dans l'armoire, le panneau de perturbation de flux (27, 37) étant disposé dans la cavité interne (210) ou/et la cavité externe (230) et étant configuré pour convertir le flux d'air de circulation interne (A) ou/et le flux d'air de circulation externe (B) en un flux tourbillonnaire ;
la plaque thermoconductrice (25, 35) ayant une forme en zigzag, au moins deux premières parties saillantes (251, 351) faisant face à la paroi interne (21, 31) et au moins deux secondes parties saillantes (252, 352) faisant face à la paroi externe (23, 33) étant disposées sur la plaque thermoconductrice (25, 35), un espace entre deux premières parties saillantes adjacentes (251, 351) formant un premier passage d'air (26, 36) dans lequel le flux d'air de circulation interne (A) s'écoule, un espace entre deux secondes parties saillantes adjacentes (252, 352) formant un second passage d'air (28, 38) dans lequel le flux d'air de circulation externe (B) s'écoule ;
**caractérisée en ce que**
une pièce de raccordement (29, 39) est en outre disposée dans l'armoire, la pièce de raccordement (19, 29, 39) est une feuille en forme de U et est serrée et fixée sur la première partie en saillie (251, 351) ou la seconde partie en saillie (252, 352), et le panneau de perturbation de flux (27, 37) est raccordé à la pièce de raccordement (29, 39) de sorte que le panneau de perturbation de flux (27, 37) disposé sur un extérieur de la pièce de raccordement est placé dans le premier passage d'air (26, 36) ou le second passage d'air (28, 38).

2. Armoire selon la revendication 1, un angle compris entre le panneau de perturbation de flux (27, 37) et une direction de flux du flux d'air de circulation interne (A) et/ou un angle compris entre le panneau de perturbation de flux (27, 37) et une direction de flux du flux d'air de circulation externe (B) variant de 15 degrés à 75 degrés.

3. Armoire selon la revendication 2, l'angle compris entre le panneau de perturbation de flux (27, 37) et la direction de flux du flux d'air de circulation interne (A) et/ou l'angle compris entre le panneau de perturbation de flux (27, 37) et la direction de flux du flux d'air de circulation externe (B) étant de 45 degrés.

4. Armoire selon la revendication 1, le panneau de perturbation de flux (27, 37) étant l'un quelconque parmi un panneau en forme de triangle, un panneau en forme de rectangle, un panneau en forme de trapèze ou un panneau en forme de parallélogramme.

5. Armoire selon la revendication 1, au moins un des panneaux de perturbation de flux (27, 37) étant disposé dans n'importe quel premier passage d'air (26, 36), et au moins un des panneaux de perturbation de flux (27, 37) étant disposé dans n'importe quel second passage d'air (28, 38) et au moins une paire des panneaux de perturbation de flux (27, 37) étant disposée dans chaque premier passage d'air (26, 36) ou chaque second passage d'air (28, 38), et les deux panneaux de perturbation de flux (27, 37) dans chaque paire de panneaux de perturbation de flux (27, 37) étant symétriques en miroir.

6. Armoire selon la revendication 5, un angle compris entre la paire de panneaux de perturbation de flux (27, 37) étant de 90 degrés.

7. Armoire selon la revendication 1, le panneau de perturbation de flux (27, 37) étant moulé en une seule pièce avec la pièce de raccordement (29, 39).

8. Armoire selon l'une quelconque des revendications 1 à 4, de multiples colonnes des panneaux de perturbation de flux (27, 37) étant disposées dans l'armoire le long d'une direction de flux d'air dans de multiples premiers passages d'air (26, 36), les panneaux de perturbation de flux (27, 37) dans des colonnes adjacentes étant situés dans différents premiers passages d'air (26, 36).

9. Armoire selon l'une quelconque des revendications 1 à 4, de multiples colonnes des panneaux de perturbation de flux (27, 37) étant disposées dans l'armoire le long d'une direction de flux d'air dans de multiples seconds passages d'air (28, 38), les panneaux de perturbation de flux dans des colonnes adjacentes étant situés dans différents seconds passages d'air (28, 38).
